Europäisches Patentamt

European Patent Office

Office européen des brevets

(19)

(11) Publication number: **0 147 471**

**A1**

(12)

# EUROPEAN PATENT APPLICATION

published in accordance with Art. 158(3) EPC

(21) Application number: 84902212.4

(22) Date of filing: 06.06.84

Data of the international application taken as a basis: .

(86) International application number:
PCT/JP84/00291

(87) International publication number:
WO84/04995 (20.12.84 84/30)

(51) Int. Cl.⁴: H 01 L 21/205

(30) Priority: 06.06.83 JP 100592/83

(43) Date of publication of application:
10.07.85 Bulletin 85/28

(84) Designated Contracting States:
DE FR GB NL

(71) Applicant: SONY CORPORATION
7-35 Kitashinagawa 6-Chome Shinagawa-ku
Tokyo 141(JP)

(72) Inventor: HAYASHI, Hisao Sony Corporation
7-35, Kitashinagawa 6-chome Shinagawa-ku
Tokyo 141(JP)

(72) Inventor: YAMOTO, Hisayoshi Sony Corporation
7-35, Kitashinagawa 6-chome Shinagawa-ku
Tokyo 141(JP)

(74) Representative: Patentanwälte TER MEER - MÜLLER -
STEINMEISTER
Mauerkircherstrasse 45
D-8000 München 80(DE)

(54) METHOD OF MANUFACTURING SEMICONDUCTOR DEVICE.

(57) A semiconductor device manufacturing method includes an epitaxial growth step in which a polycrystalline semiconductor layer and a single-crystal semiconductor layer are selectively and simultaneously formed on a semiconductor substrate. Before the epitaxial growth step, an underlayer (12) for the formation of the polycrystalline layer, which has a surface layer a layer (12b) of a substance which will not react with the gas supplied to the surface of a semiconductor substrate (11) during the epitaxial growth step, is formed over a portion of the semiconductor substrate (11) at which the polycrystalline semiconductor layer will be formed. By so doing, it is possible to prevent the formation of a single crystal or large crystal grains in the boundary between a polycrystalline semiconductor layer (13p) and a single-crystal semiconductor layer (13s) formed simultaneously by epitaxial growth, so as to make clear the boundary between the polycrystalline semiconductor layer and the single-crystal semiconductor layer.

FIG. 4

DESCRIPTION

TITLE OF THE INVENTION

METHOD FOR MANUFACTURING A SEMICONDUCTOR DEVICE

TECHNICAL FIELD

The present invention relates to a method for manufacturing a semiconductor device and particularly relates to a method for manufacturing a semiconductor device which includes an epitaxial growth process for selectively growing a polycrystalline semiconductive layer and a single crystal semiconductive layer on a single crystal semiconductive substrate at the same time.

BACKGROUND ART

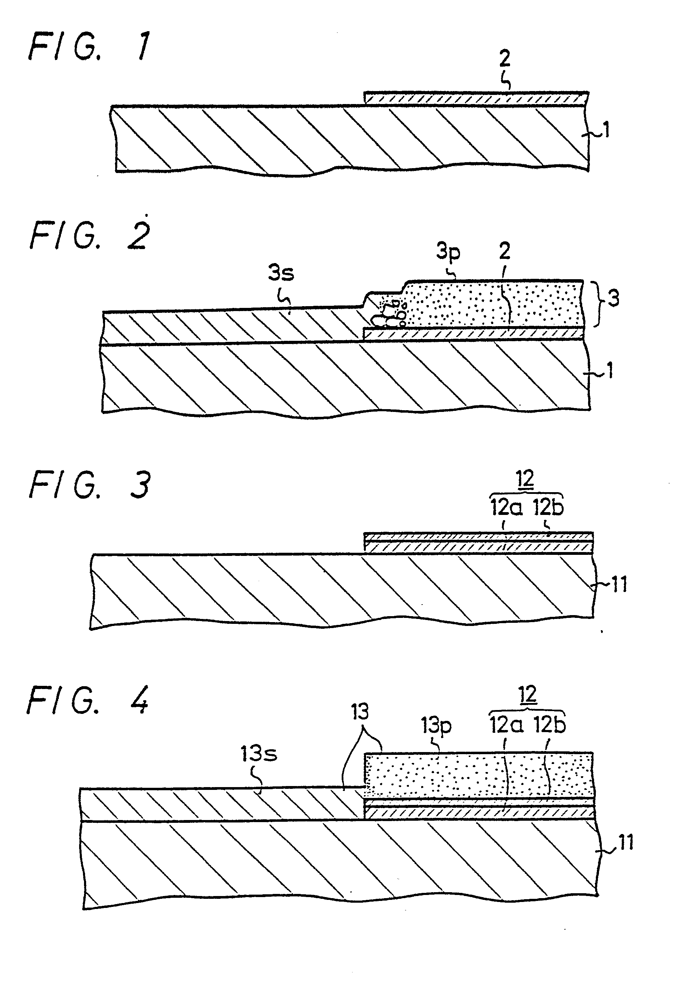

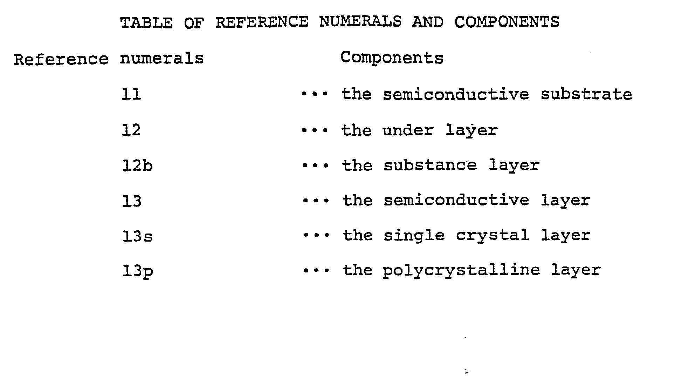

In a manufacturing process of various semiconductor devices, it is frequently carried out that a single crystal Si semiconductive layer and a polycrystalline Si semiconductive layer are selectively formed on a single crystal Si semiconductive substrate by the same process. When the polycrystalline layer and the single crystal layer are grown by the same process, usually, as shown in Fig. 1, an $SiO_2$ layer 2 is formed on a surface of a single crystal Si semiconductive substrate 1 at the portion where the polycrystalline layer is to be grown, the single crystal surface of the Si semiconductive substrate itself is exposed on its portion where the single crystal layer is to be grown and thereafter, Si epitaxial growth process is carried out so as to form an Si semiconductive layer 3. Thus, as shown in

0147471

Fig. 2, there are grown as a single crystal layer 3s which inherits the orientation relation of the single crystal of the substrate 1 in the portion where it is directly grown on the surface of the single crystal of the Si semiconductive substrate 1 and as a polycrystalline layer 3p on the $SiO_2$ layer 2 which does not inherit the orientation relation of the crystal of the substrate 1.  As described above, on the surface of the substrate 1, by forming $SiO_2$ layer 2 selectively on which the polycrystalline layer is formed, upon epitaxial growth process of the single crystal layer, the polycrystalline layer is selectively formed.  However, according to this method, in practice, even on the part of the $SiO_2$ layer 2 where the polycrystalline layer 3p is to be inherently formed, at the edge portion of the $SiO_2$ layer 2, in other words, in the portion adjacent to the exposed surface of the substrate 1 itself, even on the $SiO_2$ layer 2, the single crystal layer or large single crystal grains are grown and hence the boundary between the single crystal layer 3s and the polycrystalline layer 3p is not formed clearly so that the fine pattern of the both layers 3s and 3p can not be formed.

The present invention is to provide a method for manufacturing a semiconductor device in which the single crystal semiconductive layer and the polycrystalline semiconductive layer can selectively be formed with clearness and accordingly, with a fine pattern.

- 3 -

0147471

DISCLOSURE OF INVENTION

In the present invention, in the method for manufacturing a semiconductor device which includes an epitaxial growth process for selectively forming a polycrystalline semiconductive layer and a single crystal semiconductive layer on a semiconductive substrate simultaneously, prior to the epitaxial growth process, formed on the semiconductive substrate at its portion where the polycrystalline semiconductive layer is to be formed is an under layer on which the polycrystalline layer is formed and which includes as at least its surface layer a substance layer which does not react with a gas supplied to the surface of the semiconductive substrate in the epitaxial growth process. Then, the gas is supplied upon the surface of the semiconductive substrate having the under layer whereby to carry out the epitaxial growth process such that the single crystal semiconductive layer is formed on the substrate at its portion where the surface of its single crystal is exposed.

BRIEF DESCRIPTION OF DRAWINGS

Figs. 1 and 2 are process diagrams of a prior art method for manufacturing a semiconductor device and Figs. 3 and 4 are process diagrams of an embodiment of a method for manufacturing a semiconductor device according to this invention.

BEST MODE FOR CARRYING OUT THE INVENTION

An embodiment of this invention will be described with reference to Figs. 3 and 4.

In the figures, reference numeral 11 designates a single crystal semiconductive substrate, for example, a single crystal Si semiconductive substrate on which a single crystal Si semiconductive layer and a polycrystalline Si semiconductive layer are selectively formed by the same epitaxial growth process, respectively. In this invention, as shown in Fig. 3, an under layer 12 on which the polycrystalline layer is formed is selectively formed on the surface of the substrate 11 at its portion where the polycrystalline layer is to be formed. As this under layer 12, there is formed an $SiO_2$ layer 12a of 5000 Å to 20000 Å thickness by thermally oxidizing the surface of, for example, the substrate 11 and as a surface layer 12b thereof, there is formed a substance layer which does not react with a gas which is supplied to the substrate 11 particularly when the semiconductive layer is epitaxially grown on the substrate 11, for example, $H_2$ carrier gas and $SiH_4$ as a reaction source gas. This layer 12b is formed such that a polycrystalline Si layer formed by, for example, the low pressure chemical vapor deposition method, namely, LP-CVD method or $Si_3N_4$ layer formed by the similar LP-CVD method is deposited so as to have a thickness ranging from 500 Å to 2000 Å, for example, 1000 Å. The respective layers 12a and 12b are selectively formed on the substrate 11 such

- 5 -

0147471

that they are respectively formed on the whole surface of the substrate 11 and then patterned by a photolithography technique. Then, on this substrate 11 including the under layer 12, there is carried out the epitaxial growth process using, for example, $SiH_4$ as the source gas at substrate temperature of 1050°C so as to form a semiconductive layer 13 of, for example, 1.0 μm thickness as shown in Fig. 4. Thus, the semiconductive layer deposited to the portion where the under layer 12 exists, is an Si polycrystalline layer 13p, while an Si single crystal layer 13s is formed on the portion where no under layer 12 exists and the single crystal surface of the substrate is exposed. In this case, the boundary line between the polycrystalline layer 13p and the single crystal layer 13s becomes a clear pattern which is along the edge portion of the pattern of the under layer 12.

As described above, according to this invention, although the polycrystalline layer 13p and the single crystal layer 13s of the semiconductive layer 13 are formed simultaneously by the same process the pattern of the both can be formed as a clear pattern excellent in sharpness so that the polycrystalline layer 13p and the single crystal layer 13s can selectively be formed with fine pattern and with high precision. Thus, this invention is great in advantage of being applied to a high density integrated circuit.

According to the above manufacturing method of this invention, the single crystal layer and the polycrystalline layer can be selectively formed as the clear pattern with high precision. The reason for this will be considered as follows. When only the SiO$_2$ layer 2 is used as the under layer to form the polycrystalline semiconductive material like the prior art method described in connection with Figs. 1 and 2, if a gas which will grow the Si layer, namely, SiH$_4$ together with H$_2$ carrier gas is supplied thereon, a part of the SiO$_2$ under layer 2 is etched and reduced by the H$_2$ carrier gas so that the SiO$_2$ layer 2 becomes insufficient in the function acting as the uncleus of the polycrystal growth. Particularly the portion adjacent to the portion where the SiO$_2$ layer 2 is not deposited and the Si surface is exposed, namely, the edge portion of the SiO$_2$ under layer 2 is affected by the growth of the single crystal from the single crystal Si surface, to thereby cause the single crystal layer or large crystal grains to be grown. However, according to this invention, since the surface layer 12b which does not react with the gas supllied to the substrate upon epitaxial growth process is formed at least on the surface of the under layer 12 on which the polycrystalline layer is formed, it becomes possible to avoid the disadvantageous phenomenon inherent in the prior art method.

- 7 -

0147471

CLAIM

A method for manufacturing a semiconductor device including an epitaxial growth process for selectively forming a polycrystalline semiconductive layer and a single crystal semiconductive layer on a semiconductive substrate simultaneously, said method comprising a step in which prior to said epitaxial growth process, an under layer on which a polycrystalline layer is formed and which includes at least as its surface layer a substance layer which does not react with a gas supplied to the surface of said semiconductive substrate upon said epitaxial growth process is formed on said semiconductive substrate at its portion where said polycrystalline semiconductive layer is to be formed.

0147471

(substituted)

CLAIM

A method for manufacturing a semiconductor device including an epitaxial growth process for selectively forming a polycrystalline semiconductive layer and a single crystal semiconductive layer on a semiconductive substrate simultaneously, which is characterized in that prior to said epitaxial process, an under layer having a nitride layer as at least its surface layer is formed on said semiconductive substrate at its portion where said polycrystalline semiconductive layer is to be formed.

**FIG. 1**

**FIG. 2**

**FIG. 3**

**FIG. 4**

TABLE OF REFERENCE NUMERALS AND COMPONENTS

Reference numerals         Components

| Reference numerals | Components |
|---|---|
| 11 | ⋯ the semiconductive substrate |
| 12 | ⋯ the under layer |
| 12b | ⋯ the substance layer |
| 13 | ⋯ the semiconductive layer |
| 13s | ⋯ the single crystal layer |
| 13p | ⋯ the polycrystalline layer |

# INTERNATIONAL SEARCH REPORT

0147471

International Application No. PCT/JP84/00291

## I. CLASSIFICATION OF SUBJECT MATTER (if several classification symbols apply, indicate all) [3]

According to International Patent Classification (IPC) or to both National Classification and IPC

Int. Cl³ HO1L 21/205

## II. FIELDS SEARCHED

| Minimum Documentation Searched [4] | |
|---|---|
| Classification System | Classification Symbols |
| IPC | HO1L 21/205 |

Documentation Searched other than Minimum Documentation
to the Extent that such Documents are Included in the Fields Searched [5]

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| X | JP, B1, 50-5030 (Nippon Electric Co., Ltd.) 27 February 1975 (27. 02. 75) | 1 |
| Y | JP, B1, 46-19003 (Sony Corp.) 27 May 1971 (27. 05. 71) | 1 |
| Y' | JP, B1, 48-26180 (Sony Corp.) 7 August 1973 (07. 08. 73) | 1 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| August 29, 1984 (29. 08. 84) | September 10, 1984 (10. 09. 84) |
| International Searching Authority [1] | Signature of Authorized Officer [20] |
| Japanese Patent Office | |

Form PCT/ISA/210 (second sheet) (October 1981)